# EUROPEAN PATENT SPECIFICATION

(11) **EP 2 380 196 B1**
(45) Date of publication and mention of the grant of the patent: **08.06.2016**
(21) Application number: 10700172.9
(22) Date of filing: 12.01.2010
(51) Int. Cl.: H01L 23/13, H01L 23/14, H01L 23/498

(54) **SEMICONDUCTOR-BASED SUBMOUNT WITH ELECTRICALLY CONDUCTIVE FEED-THROUGHS**
SUBMOUNT AUF HALBLEITERBASIS MIT ELEKTRISCH LEITENDEN DURCHFÜHRUNGEN
EMBASE A BASE DE SEMI-CONDUCTEUR A TROUS D'INTERCONNEXION ELECTRIQUEMENT CONDUCTEURS

(30) Priority: 14.01.2009 US 144525 P; 27.04.2009 US 430591
(43) Date of publication of application: 26.10.2011
(73) Proprietor: Epistar Corporation, Hsinchu 300 (TW)
(72) Inventor: SHIV, Lior, DK-3400 Hilleroed (DK); SHEPHERD, John, Nicholas, A-6091 Gotzens (AT)
(74) Representative: Ter Meer Steinmeister & Partner
(86) International application number: PCT/EP2010/050265
(87) International publication number: WO 2010/081795

(56) References cited:
- WO-A1-2008/098832
- US-A1- 2005 180 698
- US-A1- 2007 170 450
- US-A1- 2008 036 045
- US-A1- 2009 108 411

## Description

### TECHNICAL FIELD

This disclosure relates to semiconductor-based submounts with electrically conductive feed-throughs.

### BACKGROUND

The operation of some semiconductor devices is relatively inefficient and generates heat during normal operation. This places limitations on the packaging materials that can be used. Preferably, the material should have high thermal conductivity and comparable thermal expansion properties to the semiconductor device itself. In recent developments, silicon has been used as a packaging material because of its thermal properties and mature silicon processing capabilities. The overall size of the package should be as small as possible to avoid high costs relative to the costs of the semiconductor device itself. Unfortunately, for situations in which the electrical feed-throughs are present in the planar and parallel surfaces of the package, additional area is needed. The result is that the overall package is much larger and costs significantly more than the semiconductor device.

As features and capabilities of consumer electronic products grow, there is an increasing need to fit more micro-components (e.g., electrical circuit components, integrated circuit dies, light emitting diodes (LEDs), thermistors, diodes, rectifiers, temperature sensors, and LED drivers) in a smaller space. Typically, the dimensions of a printed circuit board (PCB) are dictated by the size of the consumer electronic product and the available space within the product. For example, in some consumer electronics such as mobile phones or other handheld products, the height of an assembled micro-component on a PCB (e.g., the micro-components mounted on both sides of the PCB) is limited to be about one millimeter (mm), whereas the typical height of the assembled PCB is 1.5 mm (a typical height of a PCB is 500 microns (µm) and a typical height of micro-components is 500 µm). Therefore, either the size of the assembled PCB must be reduced or features and capabilities must be reduced to fit the assembled micro-components into the limited available space. In addition, thermal performance of the micro-components is also a consideration.

US 2009/0108411 A1 discloses a silicon substrate for package, i.e. the submount for a micro-component having a cavity for accommodating a micro-component, a thin silicon membrane portion at the bottom of the cavity and a thicker frame portion adjacent to side walls of the cavity. The contact between a conductive layer on a surface of the cavity and a conductive layer on the rear side of the submount is made through the silicon membrane portion at the bottom of the cavity.

Similar submounts are known from WO 2008/098832 A1, US 2007/170450 A1, and US 2005/180698 A1.

US 2008/0036045 A1 discloses a package-base structure or submount for a micro-component having a cavity which is surrounded by a thicker frame portion. The contact between conductive elements on the bottom of the cavity and the rear side of the submount is made through the thicker frame portion.

### SUMMARY

Various aspects of the invention are set forth in the claims.

Different embodiments of a submount for micro-components are disclosed. In one aspect, the submount includes a semiconductor substrate having a cavity defined in a front-side of the substrate in which to mount the micro-component. The substrate includes a thin silicon membrane portion at a bottom of the cavity and thicker frame portions adjacent to sidewalls of the cavity. The submount also includes an electrically conductive feed-through connection extending from a back-side of the substrate at least partially through the thicker silicon frame portion. Electrical contact between the feed-through connection and a conductive layer on a surface of the cavity is made at least partially through a sidewall of the cavity.

The details of one or more embodiments are set forth in the accompanying drawings and the description below. Methods of fabrication are disclosed as well.

Other features and advantages of the invention will be apparent from the description and drawings, and from the claims.

### BRIEF DESCRIPTION OF DRAWINGS

FIG 1 is a cross-sectional view of an example semiconductor-based submount.
FIG 2 is a partial view of an example semiconductor-based submount.
FIG 3 is a partial view of an example semiconductor-based submount.
FIG. 4 is a partial view of an example semiconductor-based submount.
FIG 5A is a top-view of an example semiconductor-based submount.
FIG. 5B is a cross-sectional view of the example semiconductor-based submount shown in FIG 5A.
FIG 5C is an enlarged partial view of the example semiconductor-based submount shown in FIG 5B.
FIG 5D is an enlarged partial view of the example semiconductor-based submount shown in FIG 5A.
FIG. 6 is a flowchart illustrating an example process to fabricate a semiconductor-based submount.
FIG. 7 is an illustration of a semiconductor wafer.
FIG. 8 is a partial view of an example semiconductor-based submount.
FIG. 9 is a partial view of an example semiconductor-based submount.
FIG. 10 is a partial view of an example semiconductor-based submount.
FIG. 11 is a partial view of an example semiconductor-based submount.
FIG. 12 is a partial view of an example semiconductor-based submount.

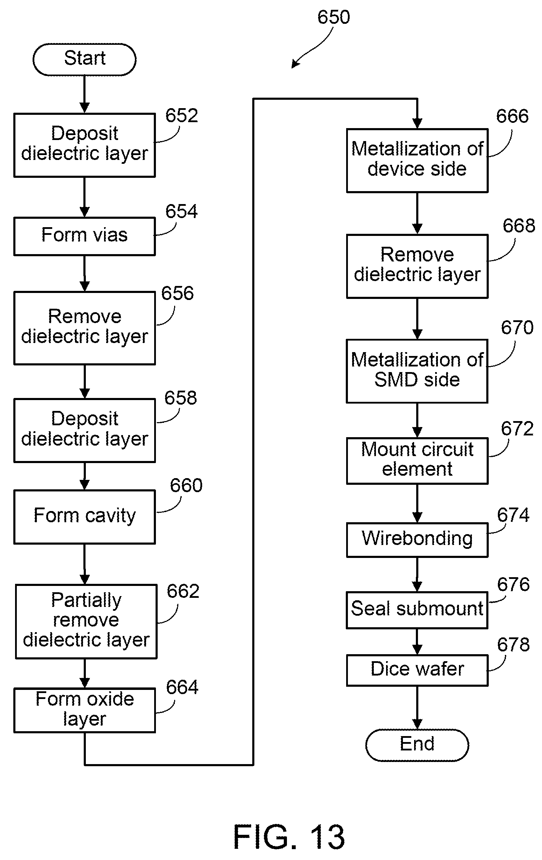

FIG. 13 is a flowchart illustrating an example process to fabricate a semiconductor-based submount.

### DETAILED DESCRIPTION

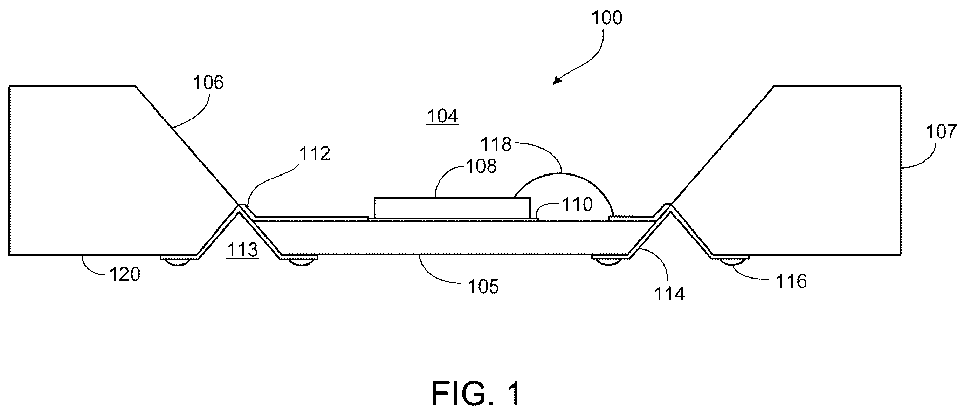

FIG. 1 illustrates a cross-sectional view of an example semiconductor-based submount 100. The submount 100 includes a substrate that has a cavity 104, a thin membrane portion 105, sidewalls 106, and a frame portion 107. The submount 100 also a micro-component 108, a die attach pad 110, cavity metallization 112, vias 113, feed-through metallization 114 and solder bumps 116 and wire bonds 118. The physical dimensions (e.g., the height and width) of the submount 100 can be increased or decreased to accommodate micro-components 108 having different sizes and/or shapes. In a particular example, the submount 100 has a height of 650 µm and a width of 2500 µm.

The submount 100 can be formed from a silicon or other semiconductor wafer. The cavity 104 is formed in the substrate, for example, by an etching process, such as a wet etching process (e.g., potassium hydroxide ("KOH") etching) or a dry etching process (e.g., Bosch process etching). Other processes can be used to form the cavity 104. The cavity 104 is configured to house the micro-component 108. The physical dimensions of the cavity 104 can be increased or decreased to accommodate different size micro-components 108 or different applications. In addition, the size of the cavity 104 can be increased or decreased to accommodate multiple micro-components 108.

The thin membrane portion 105 is at the bottom of the cavity 104 and can be a relatively thin layer of semiconductor material (e.g., silicon) that is integrated with the frame portion 107 which is thicker than the thin membrane portion 105. In a particular example, the frame portion 107 is 650 µm thick and the membrane portion 105 has a thickness of 150 µm. Both the membrane portion 105 and the frame portion 105 are made of the same material.

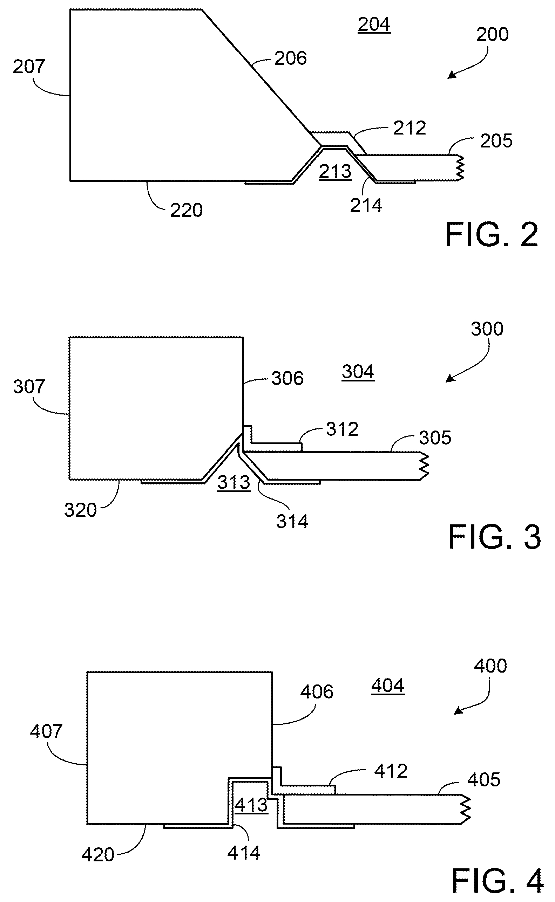

The sidewalls 106 of the cavity 104 can be angled, substantially vertical, a combination of angled and substantially vertical, or some other shape. In the illustrated example, the sidewalls 106 are slanted and result in the cavity 104 having a cross-sectional shape similar to a trapezoid. The shape of the sidewalls 106 can vary depending on the intended use of the submount 100 or the micro-component 108 placed in the cavity. For example, in some implementations, the sidewalls 106 are substantially vertical and results in the cavity 104 having a cross-sectional shape similar to a rectangle. *See* FIG. 3. In other implementations, the sidewalls 106 have a round parabolic shape.

Cavity metallization 112 can be provided on the inner surfaces of the cavity 104. Metals such as chromium, titanium, gold, copper, nickel, aluminum, and silver are deposited on predetermined portions of the inner surfaces of the cavity 104. For example, metal can be deposited on predetermined portions of the surface of the sidewalls 106 and portions of the upper surface of the membrane portion 105 (i.e., the device-side of the membrane portion 105). In some implementations, metal is selectively deposited on the membrane portion 105 to form contact pads (e.g., cathode and anode pads electrically connected to the micro-component 108 or the cavity metallization 112) and the die attach pad 110 on the upper surface of the membrane portion 105. As illustrated in FIG. 1, the cavity metallization 112 covers portions of the sidewalls 106 and portions of the upper surface of the membrane portion 105. The cavity metallization 112 forms an electrical connection with the feed-through metallization 114 through holes in the sidewalls 106 and/or the upper surface of the membrane portion 105.

The micro-component 108 can be any type of micro-component. For example, the micro-component 108 can be an electrical circuit component (e.g., a resistor or capacitor), an integrated circuit die, a LED, a LED driver, an opto-electronic component (e.g., an infrared transceiver), or a micro-electro-mechanical system circuit (MEMS). The micro-component 108 is mounted to the die attach pad 110. The micro-component 108 can be mounted to the die attach pad 110 using an adhesive bonding process or some other mounting process such as a gold-tin (AuSn) bonding process. The micro-component 108 is electrically connected to the cavity metallization 112, the die attach pad 110 and/or the feed-through metallization 114 via the wire bonds 118 connected from the micro-component 108. In some implementations, the die attach pad 110 can act as an electrical ground electrode or anode pad and be connected to the cavity metallization 112. In other implementations, the micro-component 108 is electrically connected to the cavity metallization 112, the die attach pad 110 and/or the feed-through metallization 114 by flip-chip bonding.

The submount 100 also contains one or more vias 113 with feed-through metallization 114. The vias 113 can be formed using a wet etching process, a dry etching process, a combination of wet and dry etching processes or some other etching technique. The shape of the vias 113 depends on the type of etching used to form the vias 113. For example, the vias 113 in the example of FIG. 1 are formed by a KOH etching process (i.e., a wet etching process). The vias 113 are formed such that they penetrate the sidewalls 106. In some implementations, the vias 113 are formed such that they penetrate the sidewalls 106 and entirely penetrate the membrane portion 105. The holes formed through the sidewall 106 are connections between the feed-through metallization 114 and the micro-component 108 or the cavity metallization 112.

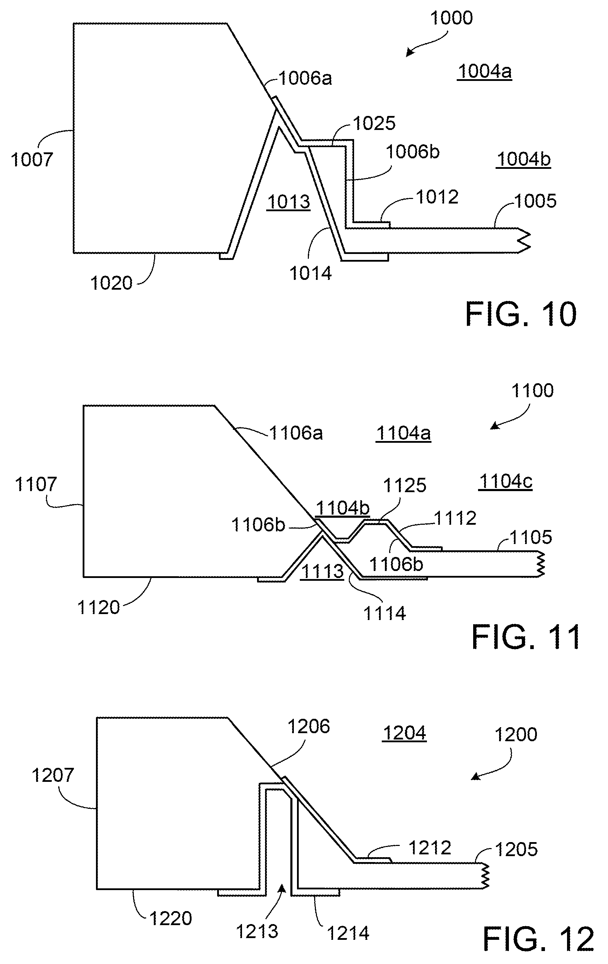

The feed-through metallization 114 extends at least partially through the frame portion 107 to the surface-mount-device (SMD) side 120 of the submount 100. In some cases, the feed-through metallization 114 only extends through the frame portion 107 (*see* FIG. 12). As illustrated in the example of FIG. 1, the feed-through metallization 114 is electrically connected to the cavity metallization 112 through a hole in the sidewall 106. In some implementations, the feed-through metallization 114 is electrically connected to the cavity metallization 112 through a hole in the sidewall 106 and the upper surface of the membrane portion 105. In addition, in the illustrated example, the feed-through metallization 114 extends along the SMD side 120 of the membrane portion 105 and frame portion 107 and is electrically connected to solder bumps 116 attached to the SMD side 120 of the submount 100. In some implementations, the feed-through metallization 114 extends only underneath the frame portion 107 and does not extend underneath the membrane portion 105.

FIG. 2 is a partial cross-sectional view of another example of a semiconductor-based submount 200. The cavity 204 can be formed by using a wet etching process that forms angled sidewalls 206 (e.g., KOH etching). The membrane portion 205 and frame portion 207 can be formed from silicon or another semiconductor. The jagged lines shown at the right side of the membrane 205 indicate that only a portion of the membrane 205 and submount 200 is shown and that the submount extends further. The via 213 is formed using a wet etching process and positioned such that the sidewalls of the via 213 and cavity 204 are offset from one another. For example, as illustrated in the cross-sectional view of FIG. 2, the via 213 is formed such that the right-most sidewall of the via213 is not aligned with the sidewall 206 and is positioned to the right of the sidewall 206. The via 213 penetrates both the sidewall 206 and the membrane 205. The feed-through metallization 214 covers the surfaces of the via 213 and portions of the SMD side 220 surfaces of the membrane 205 and the frame 207. The cavity metallization 212 covers a portion of the sidewall 206 and a portion of the membrane 205. The feed-through metallization 214 is electrically connected to the cavity metallization 212 through the hole in the sidewall 206 and the membrane 205.

FIG. 3 is a partial cross-sectional view of another example of a semiconductor-based submount 300. The cavity 304 in the submount 300 can be formed by a dry etching process that forms substantially vertical sidewalls 306. For example, a Bosch process etch can be used to form the cavity 304. As illustrated in FIG. 3, the via 313 is formed using a wet etching process and has a cross-sectional profile similar to a shark fin. The via 313 is formed so as to penetrate the sidewall 306 and form a hole in the sidewall 306. The feed-through metallization 314 covers the surfaces of the via 313 and portions of the SMD side 320 surfaces of the membrane 305 and the frame 307. The feed-through metallization 314 is electrically connected to the cavity metallization 312 through the hole in the sidewall 306. The cavity metallization 312 covers portions of the sidewall 306 and portions of the upper surface of the membrane 305. In some implementations, the via 313 penetrates both the membrane 305 and the sidewall 306.

FIG. 4 is a partial cross-sectional view of yet another example of a semiconductor-based submount 400. The cavity 404 of submount 400 can be formed by a dry etching process that forms substantially vertical sidewalls 406. The via 413 is formed using a dry etching process similar to the dry etching process used to create the cavity 404 and has substantially vertical sidewalls. The via 413 penetrates the sidewall 406 and the membrane 405. The feed-through metallization 414 covers the surfaces of the via 413 and portions of the SMD side 420 surfaces of the membrane 405 and the frame 407. The feed-through metallization 414 is electrically connected to the cavity metallization 412 through the hole in the sidewall 406 and the membrane 405.

In some implementations, the feed-through metallization extends entirely through the frame portion. For example, the submount 1200 of FIG. 12 includes a via 1213 that extends from the SMD side 1220 of the submount 1200 and through the frame portion 1207. The feed-through metallization 1214 is electrically connected to the cavity metallization 1212.

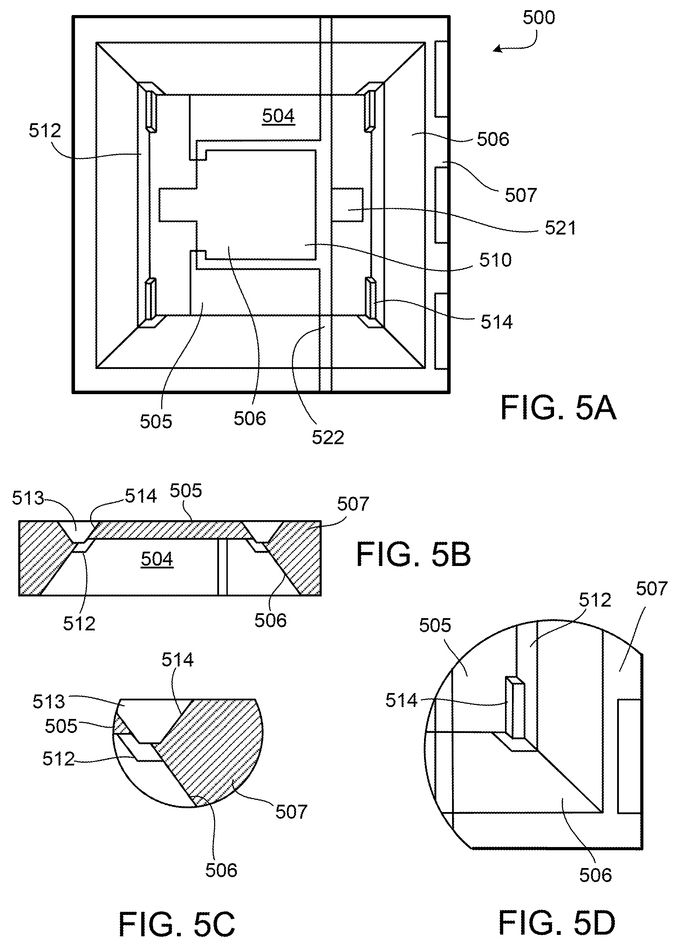

FIG. 5A is a top-view of a silicon-based submount 500. As illustrated in FIG. 5A, the sidewalls 506 of the cavity 504 are slanted. The sidewalls 506 begin at the top of the frame 507 and ends at the upper surface of the membrane 505. The cavity 504 includes cavity metallization 512 which is structured to cover the feed-through metallization 514, a die attach pad 510, and wire bond pad 521. The submount 500 also includes nonconductive isolation regions, such as SiO2, to separate the die attach pad 510 and the wire bond pad 521.

Example dimensions of the submount 500 are shown in FIG. 5A. Different dimensions may be appropriate for other implementations. As illustrated in FIG. 5A, the submount 500 has a square shape with sides that are 2500 µm in length. The membrane 505 also is square shaped and has sides of about 1473 µm in length. The width at the top of the cavity 504 is 2180 µm.

FIG. 5B is an inverted cross-sectional view of the submount 500. As illustrated in the example of FIG. 5B, the frame 507 has a thickness of 650 µm. The sidewalls of the vias 513 are not aligned with the sidewalls 506 of the cavity 504. The feed-through metallization 514 covering the surfaces of the vias 513 extends from the SMD side 120 of the submount 500 and penetrate the sidewalls 506 and a portion of the membrane 505. The feed-through metallization 514 forms an electrical connection with the cavity metallization 512.

FIG. 5C is an enlarged partial view of FIG. 5B and shows the portion of the submount 500 where the via 513 penetrates the sidewall 506 and the membrane 505. As illustrated in the example of FIG. 5C, the membrane 505 has a thickness of approximately 150 µm and the via 513 has a depth of approximately 190 µm. In this example, via 513 has a maximum width of 359 µm.

FIG. 5D is an enlarged partial top-view of the submount 500. In this example, the feed-through metallization 514 has a width of 45 µm and a length of 245 µm. The cavity metallization 512 has a width of 105 µm and covers the feed-through metallization 514 and portions of the membrane 505 and sidewalls 506.

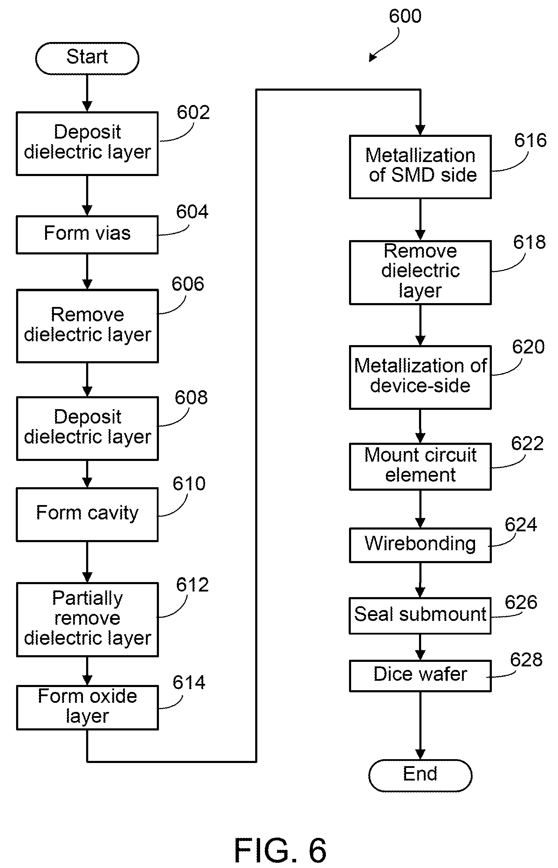

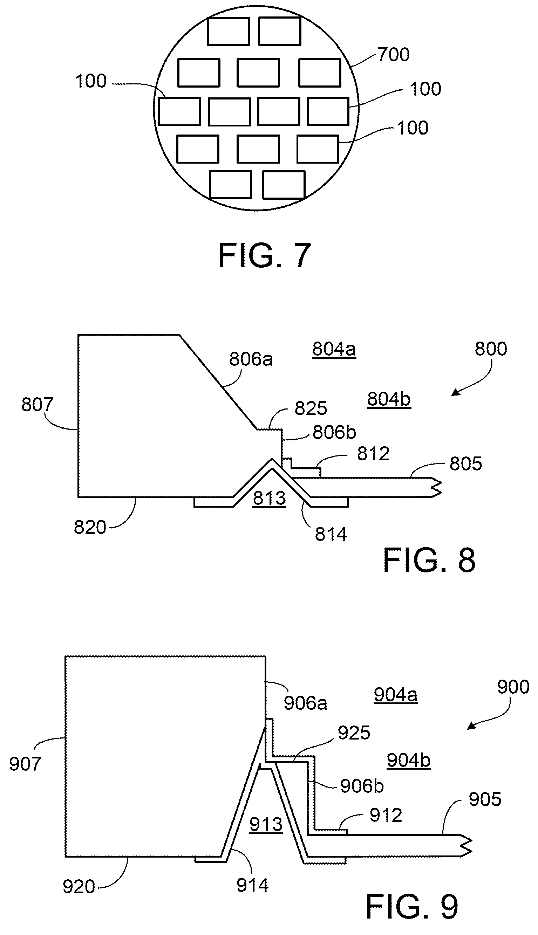

FIG. 6 is a flowchart illustrating a wafer-level process 600 to form a submount similar to the submount 100. Processes similar to process 600 can be used to form the other example submounts described above and below. The process 600 is typically performed on a silicon or other semiconductor wafer to fabricate multiple discrete submounts. An example of a semiconductor wafer 700 with areas defining multiple submounts 100 is shown in FIG. 7. Although the fabrication process can be performed at the wafer level, for ease of discussion, the individual steps of process 600 are described below as being performed with respect to a section of the semiconductor wafer 700 defining a single submount 100.

The process 600 begins with a silicon or other semiconductor wafer having a thickness equal to, for example, 650 µm. A dielectric layer is formed on predetermined portions of the SMD side 120 of the submount 100 and on predetermined portions of the device side of the submount 100 (block 602). The dielectric layer can be any type of dielectric that acts as an etch resistant layer. For example, silicon dioxide (SiO₂) can be used as the dielectric layer.

One or more vias 113 then are etched into the SMD side 120 of the submount 100 (block 604). The vias 113 can be etched using a wet etching technique such as potassium hydroxide (KOH) etching or tetramethyl ammonium hydroxide (TMAH) etching. Alternatively, the vias 113 can be etched using a dry etching technique, such as Bosch process etching (i.e., time-multiplexed etching). In some implementations, other etching techniques can be used or a combination of etching techniques can be used. As described above, the choice of etching technique affects the shape of the vias 113. A wet etching technique can yield vias similar to the vias 113, 213 and 313, which are illustrated in FIGS. 1-3 respectively. A dry etching technique can yield vias similar to via 414, which is illustrated in FIG. 4. The vias 113 are etched to a predetermined depth that is greater than the thickness of the membrane portion 105. For example, in some implementations, the membrane portion 105 has a thickness equal to 150 µm and the vias 113 are etched to a depth of approximately 190 µm.

The submount 100 is then processed to remove the dielectric layer from the SMD side 120 of the submount 100 and from the device side of the submount 100 (block 606). The dielectric layer can be removed using any known technique such as etching.

A dielectric layer is formed or deposited on the SMD side 120 of the submount 100 and the device side of the submount 100 (block 608). For example, a dielectric layer can be formed to cover the surfaces of the vias 113. The dielectric layer also can be formed on predetermined portions of the SMD side 120 of the submount 100. The dielectric layer can be any type of dielectric that acts as an etch resistant layer. For example, silicon dioxide (SiO₂) can be used as the dielectric layer. In one example, the dielectric layer is formed such that the dielectric layer has a thickness of approximately 400 nm.

The device side of the submount 100 is etched to form the cavity 104 (block 610). A wet etching technique, a dry etching technique, a combination of wet and dry etching, or any other etching technique can be used to form the cavity 104. The choice of etching technique has an effect on the shape of the sidewalls 106. For example, cavity 104 has sloping sidewalls 106 and was formed using a timed wet etching technique. The cavity 104 is etched to a depth such that the sum of the depths of the cavity 104 and the vias 113 is slightly greater than the thickness of the submount 100. For example, if the submount 100 has a thickness of 650 µm, the cavity 104 can have a depth of 500 µm and the vias 113 can have a depth of 190 µm. After the cavity 104 is etched, the thin dielectric layer that was deposited in the vias 113 in block 604 is exposed.

The submount 100 can be processed to partially remove the dielectric layer from the SMD side 120 and the device side of the submount 100 (block 612). The dielectric layer can be removed from the surfaces of the vias 113 as well as predetermined portions of the SMD side 120 of the submount 100. The dielectric layer can be removed using any known technique, such as etching.

A dielectric/oxide layer is then thermally grown over the surfaces of the submount 100 (block 614). The dielectric layer can be grown over predetermined portions of the cavity 104, including the sidewalls 106 and the upper surface of the membrane portion 105, and the device side of the submount 100. The dielectric layer can be any type of dielectric that acts as an etch resistant layer, such as SiO₂. The dielectric layer can be grown to a thickness, for example, of about 1200 nm. The dielectric layer can be thermally grown to any thickness as long as it is thicker than the dielectric layer previously deposited in the vias 113 in block 604.

The SMD side 120 of the semiconductor 100 then is metallized to form the feed-through metallization 114 (block 616). The feed-through metallization 114 can be formed, for example, by the deposition of conductive metals in the vias 113. Metal can also be deposited in predetermined portions of the SMD side 120 of the membrane portion 105. Metals such as chromium, titanium, gold, copper, nickel, aluminum, and silver can be deposited on the predetermined portions of the SMD side 120 of the submount 100 and the vias 113. Different metallization techniques can be used. For example, electroplating techniques or a thin film metallization process such as sputtering deposition can be used.

The submount 100 is processed to partially remove the dielectric layer from the device side of the submount 100, including the surfaces of the cavity 104 (block 618). As described above, the dielectric layer can be removed using an etching technique. The amount of the dielectric layer that is removed from the device side of the submount 100 can vary but should be enough to expose the feed-through metallization 114 in the vias 113. For example, if the dielectric layer is grown to a thickness of 1200 nm on the frame portion 107 and to a thickness of 400 nm in the vias 113, then 400 nm of the dielectric layer can be removed. In one example, the dielectric layer is completely removed from the surfaces of the vias 113 and partially removed from the frame portion 107.

The device-side of the submount 100 (i.e., the side of the submount 100 opposite the SMD side 120) then undergoes a metallization process (block 620). Metal can be deposited in predetermined areas of the cavity 104 to form the cavity metallization 112 which is electrically connected to the feed-through metallization 114. In addition, metal can be deposited to form different structures such as the die-attach pad 110. Different metallization techniques can be used.

The micro-component 108 then is attached to the die-attach pad 110 (block 622). The micro-component 108 can be attached to the die-attach pad 110 using any form of mounting technique such as adhesive bonding. The wirebonds 118 are then attached to the micro-component 108 and connected to the cavity metallization 112 (i.e., wirebonding) (block 624). The wirebonds 118 provide for an electrical connection between the micro-component 108 and the feed-through metallization 114. In some implementations, the micro-component can be electrically connected to the cavity metallization 112 by flip-chip bonding.

After wirebonding is completed, the submount 100 is encapsulated (block 626). In some implementations, a protective cover is mounted on top of the submount 100 and hermetically sealed to the submount 100. The protective cover can be applied to the submount using any known technique. The protective cover can be made of a material with an index of refraction that can minimize internal reflections of the micro-component or can act as a filter. In other implementations, a resin is deposited in the cavity 104 and acts as to seal the micro-component 108. After the submount 100 is sealed, the individual submounts are separated by a dicing process (block 628).

Process 600 can be modified such that the cavity 104 is formed before the vias 113 are etched. In other words, in process 600 of FIG. 6, block 610 is performed in place of block 604 and block 604 is performed in place of block 610. Process 600 can also be modified such that the individual semiconductor submounts 100 are separated by a dicing process before the micro-component 108 is attached to the die-attach pad 110 and the submount 100 is sealed.

In addition, process 600 can also be modified such that the device side of the submount 100 is metallized before the SMD side 120 is metallized. For example, the process 650 is substantially the same as process 600 until block 666. In block 666, the device side of the submount 100 undergoes a metallization process (block 666). Metal can be deposited in predetermined areas of the cavity 104 to form the cavity metallization 112 which is electrically connected to the feed-through metallization 114. In addition, metal can be deposited to form different structures such as the die-attach pad 110. Different metallization techniques can be used

The dielectric layer is then removed from predetermined portions of the SMD side 120 of the submount 100 (block 668). A predetermined amount of dielectric material is removed from the SMD side 120 of the submount 100, including the surfaces of the vias 113 and the membrane 105. As described above, the dielectric layer can be removed using an etching technique.

The SMD side 120 of the semiconductor 100 then is metallized to form the feed-through metallization 114 (block 670). The feed-through metallization 114 can be formed, for example, by the deposition of conductive metals in the vias 113. Metal can also be deposited in predetermined portions of the SMD side 120 of the membrane portion 105. Metals such as chromium, titanium, gold, copper, nickel, aluminum, and silver can be deposited on the predetermined portions of the SMD side 120 of the submount 100 and the vias 113. Different metallization techniques can be used. For example, electroplating techniques or a thin film metallization process such as sputtering deposition can be used.

The remaining steps of process 650 are the same as in process 600.

A number of embodiments of the invention have been described. Nevertheless, it will be understood that various modifications may be made without departing from the spirit and scope of the invention. For example, the shape of the cavity can be modified. FIGS. 8-11 are partial views of semiconductor-based submounts in which the conductive feed-throughs extend at least partially through the thicker silicon frame portion but have cavity designs different from those described above. For example, the silicon-based submount 800 shown in FIG. 8 has two cavity regions 804a and 804b. In the illustrated example, the first cavity region 804a is formed by a wet etching process and has angled sidewalls 806a. The first cavity region 804a has a depth of approximately 300 µm and is wider than the second cavity region 804b. Due to the difference in cavity widths, a landing plan 825 is formed. The second cavity region 804b is formed by a dry etching process and has substantially vertical sidewalls 806b. The second cavity region 804b has a depth of approximately 100-150 µm. The via 813 is formed to penetrate the sidewall 806b and the membrane 805 and allows the feed-through metallization 814 to form an electrical connection with the cavity metallization 812. The cavity metallization 812 covers a portion of the substantially vertical sidewall 806b and portions of the upper surface of the membrane 805. In some implementations, the cavity metallization 812 extends from the angled sidewall 806a and covers portions of the angled sidewall 806a, the landing 825, portions of the substantially vertical sidewall 806b and portions of the upper surface of the membrane 805.

FIG. 9 is a partial cross-sectional view of a semiconductor-based submount 900 having two cavity regions 904a and 904b. The first cavity region 904a is formed by a dry etching process and has substantially vertical sidewalls 906a. The first cavity region 904a has a depth of approximately 350 µm. The second cavity region 904b is also formed by a dry etching process and has substantially vertical sidewalls 906b. The width of the second cavity region 904b is less than the width of the first cavity region 904a. The difference in widths creates a landing plan 925. In the illustrated example, the second cavity region 904b has a depth of approximately 100 µm. The via 913 penetrates the sidewall 906a and the landing plan 925 and allows the feed-through metallization 914 to form an electrical connection with the cavity metallization 912. The cavity metallization 912 extends over portions of the angled sidewall 906a, the landing plan 925, the sidewall 906b and the membrane 905.

FIG. 10 is a partial cross-sectional view of a semiconductor-based submount 1000 having two cavity regions 1004a and 1004b. The first cavity region 1004a is formed by a wet etching process and has angled sidewalls 1006a. The first cavity region 1004a has a depth of approximately 350 µm. In the illustrated example, the second cavity region 1004b is formed by a dry etching process and has substantially vertical sidewalls 1006b. The second cavity region 1004b has a depth of approximately 100 µm. The first cavity region 1004a is wider than the second cavity region 1004b and is positioned such that a landing plan 1025 is formed between the first sidewalls 1006a and the second sidewalls 1006b. The via 1013 penetrates the first sidewall 1006a and the landing plan 1025 and allows the feed-through metallization 1014 to form an electrical connection with the cavity metallization 1012. The cavity metallization 1012 extends over portions of the first sidewall 1006a, the landing plan 1025 the second sidewall 1006b, and/or the upper surface of the membrane 1005.

FIG. 11 is a partial cross-sectional view of a semiconductor-based submount 1100 configured to accommodate multiple micro-components. The submount 1100 has three cavity regions 1104a, 1104b and 1104c. The first cavity region 1104a is formed by a wet etching process and has angled sidewalls 1106a. The first cavity region 1104a is etched to a first predetermined depth. The second cavity region 1104b is formed by a wet etching process and has angled sidewalls 1106b. The second cavity region 1104b is etched to a second predetermined depth. The width of the first cavity region 1104a is larger than the width of the second cavity region 1104b. A third cavity region 1104c is formed by a wet etching process and has angled sidewalls 1106c. The third cavity region 1104c is etched to a third predetermined depth. In some implementations, the second predetermined depth can be equal to the third predetermined depth. In other implementations, the third predetermined depth can be greater than the second predetermined depth. The third cavity region 1104c is formed to the right of the second cavity region 1104b and a landing plan 1125 is created. In some implementations, a micro-component can be placed on the landing plan 1125 or on the bottom of the second cavity 1104b. The via 1113 is formed to penetrate the second sidewalls 1106b and allows the feed-through metallization 1114 to form an electrical connection with the cavity metallization 1112. The cavity metallization 1112 can be formed to extend over portions of the first sidewall 1106a, portions of the second sidewall 1106b, portions of the landing plan 1125, portions of the third sidewall 1106c and/or portions of the upper surface of the membrane 1105.

Various advantages can be obtained using the design and techniques of the present invention. Among the advantages that are obtained in some implementations are the following:
(1) The electrical feed-throughs are moved further away from critical optical surfaces of a LED (or other light emitting device) to improve device efficiency.
(2) Reduction in the overall package size and overall manufacturing costs can be achieved.
(3) Increased size of the contact area close to the LED chip to improve thermal performance.
(4) The design can exploit the fabrication technologies potential of producing sloping sidewalls of precise and repeatable geometries.
(5) The design can create a three-dimensional structure capable of metallization on each sidewall of the recess.
(6) Improved mechanical stability of the package by moving the via(s) for the feed-through metallization to a stronger region of the submount structure. Where the packaging design includes a thin membrane, the feed-through contact need not extend through the thin membrane. The mechanical integrity can thus be improved.
(7) Allows independent design of the membrane thickness and the through-contact fabrication requirements.
(8) Allows a reduction in the membrane thickness to enhance the thermal performance of the package.

Other implementations are within the scope of the claims.

## Claims

1. A submount for a micro-component, the submount (100, 200, ...) comprising:
- a semiconductor substrate having a cavity (104, 204, ...) defined in a front-side of the substrate in which to mount the micro-component (108), a thin silicon membrane portion (105, 205, ...) at a bottom of the cavity (104, 204, ...) and thicker frame portions (107, 207, ...) adjacent to sidewalls (106, 206, ...) of the cavity (104, 204, ...); **characterized by**
- an electrically conductive feed-through connection (114, 214, ...) extending from a back-side of the substrate at least partially through the thicker silicon frame portion (107, 207, ...), with electrical contact between the feed-through connection (114, 214) and a conductive layer (112, 212, ...) on a surface of the cavity being made at least partially through a sidewall (106, 206, ...) of the cavity (104, 204, ...).

2. The submount of claim 1 wherein the electrical contact is formed at least partially through the thin membrane (105, 205, ...) as well as the sidewall (106, 206, ...) of the cavity (104, 204,...).

3. The submount of claim 1 or 2 wherein the substrate is a silicon substrate.

4. The submount of one of the preceding claims further comprising a via (113, 213, ...) in the back-side of the substrate, wherein the via (113, 213, ...) has sidewalls and the electrically conductive feed-through connection (114, 214, ...) extends at least along the sidewalls of the via (113, 213, ...).

5. The submount of claim 4 wherein the sidewalls of the via (113, 213, ...) are not aligned with the sidewall (106, 206, ...) of the cavity.

6. The submount of claim 4 wherein the via (113, 213, ...) completely penetrates the thin membrane portion (105, 205, ...).

7. The semiconductor submount of one of the preceding claims wherein the cavity comprises a plurality of cavity regions (804a, 804b), wherein each of the cavity regions (804a, 804b) are separated by a landing plan (825).

8. The semiconductor submount of one of the preceding claims wherein the sidewalls (106, 206, 306, ...) of the cavity are angled or substantially vertical.

9. The semiconductor submount of one of claims 1 to 7 wherein the sidewalls of the cavity comprise an angled sidewall (806a) and a substantially vertical sidewall (806b).

10. A wafer-level method of fabricating a submount (100, ...) for a micro-component, the method comprising:
- etching a via (113,...) in a back-side of a silicon wafer (700), and etching a cavity (104, ...) in a front-side of the silicon wafer (700) to define a thin membrane portion (105, ...) at the bottom of the cavity, the wafer (700) having thicker frame portions (107, ...) adjacent sidewalls (106, ...) of the cavity (104, ...), and the via (113, ...) extends at least partially through the thicker frame portions (107, ...);
- providing metallization in the via (113, ...) to form electrically conductive feed-through connection (114, ...) that extends from the back-side of the substrate (700) at least partially through the thicker silicon frame portion (107, ...); and
- providing metallization on a surface the cavity (104, ...), wherein electrical connection between the electrically conductive feed-through connection (114, ...) and the metal on the surface of the cavity (104, ...) is made at least partially through a particular sidewall (106, ...) of the cavity (104, ...).

11. The method of claim 10 wherein the via (113, ...) is etched such that sidewalls of the via (113, ...) are not aligned with the particular sidewall (106, ...) of the cavity (104, ... ).

12. The method of any one of claims 10 to 11 wherein the cavity (104, ...) is etched using a wet etching process or a dry etching process.

13. The method of one of claims 10 to 12 wherein the cavity is etched to form a plurality of cavity regions (804a, 804b, 904a, 904b), wherein each of the cavity regions are separated by a landing plan (825, 925).

14. The method of one of claim 10 to 13 wherein etching the via (113, ...) comprises etching the via (113, ...) to a depth greater than a thickness of the thin membrane (105, ...).

## Patentansprüche

1. Montagebasis für eine Mikrokomponente, wobei die Montagebasis (100, 200, ...) Folgendes umfasst:
- ein Halbleitersubstrat, das einen Hohlraum (104, 204, ...), der in einer Vorderseite des Substrats definiert ist und in dem die Mikrokomponente (108) montiert werden soll, einen dünnen Siliciummembranabschnitt (105, 205, ...) auf einem Boden des Hohlraums (104, 204, ...) und dickere Rahmenabschnitte (107, 207, ...) in der Nähe von Seitenwänden (106, 206, ...) des Hohlraums (104, 204, ...) besitzt; **gekennzeichnet durch**
- eine elektrisch leitende Durchführungsverbindung (114, 214, ...), die sich von einer Rückseite des Substrats wenigstens teilweise **durch** den dickeren Siliciumrahmenabschnitt (107, 207, ...) erstreckt, wobei wenigstens teilweise **durch** eine Seitenwand (106, 206, ...) des Hohlraums (104, 204, ...) ein elektrischer Kontakt zwischen der Durchführungsverbindung (114, 214) und einer leitenden Schicht (112, 212, ...) auf einer Oberfläche des Hohlraums geschaffen wird.

2. Montagebasis nach Anspruch 1, wobei der elektrische Kontakt wenigstens teilweise durch die dünne Membran (105, 205, ...) sowie die Seitenwand (106, 206, ...) des Hohlraums (104, 204, ...) hindurch gebildet ist.

3. Montagebasis nach Anspruch 1 oder 2, wobei das Substrat ein Siliciumsubstrat ist.

4. Montagebasis nach einem der vorhergehenden Ansprüche, die ferner in der Rückseite des Substrats ein Durchgangsloch (113, 213, ...) umfasst, wobei das Durchgangsloch (113, 213, ...) Seitenwände besitzt und die elektrisch leitende Durchführungsverbindung (114, 214, ...) sich wenigstens längs der Seitenwände des Durchgangslochs (113, 213, ...) erstreckt.

5. Montagebasis nach Anspruch 4, wobei die Seitenwände des Durchgangslochs (113, 213, ...) nicht auf die Seitenwand (106, 206, ...) des Hohlraums ausgerichtet sind.

6. Montagebasis nach Anspruch 4, wobei das Durchgangsloch (113, 213, ...) den dünnen Membranabschnitt (105, 205, ...) vollständig durchdringt.

7. Halbleitermontagebasis nach einem der vorhergehenden Ansprüche, wobei der Hohlraum mehrere Hohlraumbereiche (804a, 804b) umfasst, wobei jeder der Hohlraumbereiche (804a, 804b) durch eine Auflageebene (825) getrennt ist.

8. Halbleitermontagebasis nach einem der vorhergehenden Ansprüche, wobei die Seitenwände (106, 206, 306, ...) des Hohlraums angewinkelt oder im Wesentlichen vertikal sind.

9. Halbleitermontagebasis nach einem der Ansprüche 1 bis 7, wobei die Seitenwände des Hohlraums eine angewinkelte Seitenwand (806a) und eine im Wesentliche vertikale Seitenwand (806b) umfassen.

10. Verfahren auf Wafer-Niveau zum Fertigen einer Montagebasis (100, ...) für eine Mikrokomponente, wobei das Verfahren Folgendes umfasst:
- Ätzen eines Durchgangslochs (113, ...) in einer Rückseite eines Silicium-Wafers (700) und Ätzen eines Hohlraums (104, ...) in einer Vorderseite des Silicium-Wafers (700), um einen dünnen Membranabschnitt (105, ...) auf dem Boden des Hohlraums zu definieren, wobei der Wafer (700) dickere Rahmenabschnitte (107, ...) in der Nähe von Seitenwänden (106, ...) des Hohlraums (104, ...) besitzt und wobei sich das Durchgangsloch (113, ...) wenigstens teilweise durch die dickeren Rahmenabschnitte (107, ...) erstreckt;
- Bereitstellen einer Metallisierung in dem Durchgangsloch (113, ...), um eine elektrisch leitende Durchgangsverbindung (114, ...) zu bilden, die sich von der Rückseite des Substrats (700) wenigstens teilweise durch den dickeren Siliciumrahmenabschnitt (107, ...) erstreckt; und
- Bereitstellen einer Metallisierung auf einer Oberfläche des Hohlraums (104, ...), wobei die elektrische Verbindung zwischen der elektrisch leitenden Durchführungsverbindung (114, ...) und dem Metall auf der Oberfläche des Hohlraums (104, ...) wenigstens teilweise durch eine bestimmte Seitenwand (106, ...) des Hohlraums (104, ...) hergestellt wird.

11. Verfahren nach Anspruch 10, wobei das Durchgangsloch (113, ...) in der Weise geätzt wird, dass Seitenwände des Durchgangslochs (113, ...) nicht auf die bestimmte Seitenwand (106, ...) des Hohlraums (104, ...) ausgerichtet sind.

12. Verfahren nach einem der Ansprüche 10 bis 11, wobei der Hohlraum (104, ...) unter Verwendung eines Nassätzprozesses oder eines Trockenätzprozesses geätzt wird.

13. Verfahren nach einem der Ansprüche 10 bis 12, wobei der Hohlraum geätzt wird, um mehrere Hohlraumbereiche (804a, 804b, 904a, 904b) zu bilden, wobei jeder der Hohlraumbereiche durch eine Auflageebene (825, 925) abgetrennt ist.

14. Verfahren nach einem der Ansprüche 10 bis 13, wobei das Ätzen des Durchgangslochs (113, ...) das Ätzen des Durchgangslochs (113, ...) bis zu einer Tiefe, die größer als eine Dicke der dünnen Membran (105, ...) ist, umfasst.

## Revendications

1. Embase pour un microcomposant, l'embase (100, 200,...) comprenant :
- un substrat de semi-conducteur possédant une cavité (104, 204,...) définie dans une face avant du substrat dans laquelle le microcomposant (108) est monté, une partie de membrane de silicium mince (105, 205, ...) au fond de la cavité (104, 204, ...) et des parties d'armature plus épaisses (107, 207, ...) adjacentes aux parois latérales (106, 206, ...) de la cavité (104, 204, ...) ; **caractérisée par**
- une connexion traversante électriquement conductrice (114, 214, ...) s'étendant à partir d'une face arrière du substrat au moins partiellement à travers la partie d'armature plus épaisse (107, 207, ...), avec un contact électrique entre la connexion traversante (114, 214) et une couche conductrice (112, 212, ...) sur une surface de la cavité étant faite au moins partiellement à travers une paroi latérale (106, 206, ...) de la cavité (104, 204, ...).

2. Embase selon la revendication 1, dans laquelle le contact électrique est formé au moins partiellement à travers la membrane fine (105, 205, ...) aussi bien qu'à travers la paroi latérale (106, 206, ...) de la cavité (104, 204, ...).

3. Embase selon la revendication 1 ou la revendication 2, dans laquelle le substrat est un sous-substrat de silicium.

4. Embase selon l'une quelconque des revendications précédentes comprenant en outre un trou d'interconnexion (113, 213, ...) dans la face arrière du substrat, dans lequel le trou d'interconnexion (113, 213, ...) possède des parois latérales et la connexion traversante électriquement conductrice (114, 214, ...) s'étend au moins le long des parois latérales du trou d'interconnexion (113, 213, ...).

5. Embase selon la revendication 4, dans laquelle les parois latérales du trou d'interconnexion (113, 213, ...) ne sont pas alignées avec la paroi latérale (106 206, ...) de la cavité.

6. Embase selon la revendication 4, dans laquelle le trou d'interconnexion (113, 213, ...) pénètre complétement la partie de membrane fine (105, 205, ...).

7. Embase de semi-conducteur selon l'une quelconque des revendications précédentes, dans laquelle la cavité comprend une pluralité de régions de cavité (804a, 804b), dans laquelle chacune des régions de cavité (804a, 804b) sont séparées par un plan d'atterrissage (825).

8. Embase de semi-conducteur selon l'une quelconque des revendications précédentes, dans laquelle les parois latérales (106, 206, 306, ...) de la cavité sont en biais ou substantiellement verticales.

9. Embase de semi-conducteur selon l'une quelconque des revendications 1 à 7 dans laquelle les parois latérales de la cavité comprennent une paroi latérale en biais (806a) et une paroi latérale substantiellement verticale (806b).

10. Procédé au niveau wafer de fabrication d'une embase (100, ...) pour un microcomposant, le procédé comprenant les étapes consistant à :
- graver un trou d'interconnexion (113, ...) dans une face arrière d'un wafer de silicium (700), et graver une cavité (104, ...) dans une face avant du wafer de silicium (700) pour définir une partie de membrane fine (105, ...) au fond de la cavité, le wafer (700) possédant des parties d'armature plus épaisses (107, ...) adjacentes aux parois latérales (106, ...) de la cavité (104, ...), et le trou d'interconnexion (113, ...) s'étend au moins partiellement à travers les parties d'armature plus épaisses (107, ...) ;
- fournir la métallisation dans le trou d'interconnexion (113, ...) pour former une connexion traversante électriquement conductrice (114, ...) qui s'étend à partir de la face arrière du substrat (700) au moins partiellement à travers la partie d'armature plus épaisse (107, ...) ; et
- fournir la métallisation sur une surface de la cavité (104, ...), dans laquelle la connexion électrique entre la connexion traversante électriquement conductrice (114, ...) et le métal sur la surface de la cavité (104, ...) est faite au moins partiellement à travers une paroi latérale particulière (106, ...) de la cavité (104, ...).

11. Procédé selon la revendication 10 dans lequel le trou d'interconnexion (113, ...) est gravé de sorte que les parois latérales du trou d'interconnexion (113, ...) ne sont pas alignées avec la paroi latérale particulière (106, ...) de la cavité (104, ...).

12. Procédé selon l'une quelconque des revendications 10 à 11, dans lequel la cavité (104, ...) est gravée en utilisant un processus d'attaque par voie humide ou un processus d'attaque par voie sèche.

13. Procédé selon l'une quelconque des revendications 10 à 12, dans lequel la cavité est gravée pour former une pluralité de régions de cavités (804a, 804b, 904a, 904b), dans laquelle chacune des régions de cavité est séparée par un plan d'atterrissage (825, 925).

14. Procédé selon l'une quelconque des revendications 10 à 13, dans lequel la gravure du trou d'interconnexion (113, ...) comprend la gravure du trou d'interconnexion (113, ...) à une profondeur plus importante qu'une épaisseur de la membrane fine (105, ...).
